# EUROPEAN PATENT SPECIFICATION

(11) **EP 4 391 782 B1**
(45) Date of publication and mention of the grant of the patent: **18.11.2026**
(21) Application number: 21954039.0
(22) Date of filing: 02.12.2021
(51) Int. Cl.: H10N 50/01, H10B 61/00

(54) **METHOD FOR REDUCING DAMAGE TO MAGNETIC TUNNEL JUNCTION OF MRAM**
VERFAHREN ZUR VERRINGERUNG DER BESCHÄDIGUNG DES MAGNETTUNNELÜBERGANGS VON MRAM
PROCÉDÉ DE RÉDUCTION DE DOMMAGES À UNE JONCTION TUNNEL MAGNÉTIQUE DE MRAM

(30) Priority: 20.08.2021 CN 202110962630
(43) Date of publication of application: 26.06.2024
(73) Proprietor: Jiangsu Leuven Instruments Co. Ltd, Xuzhou, Jiangsu 221300 (CN)
(72) Inventor: YANG, Yuxin, Xuzhou, Jiangsu 221300 (CN); LI, Jiahe, Xuzhou, Jiangsu 221300 (CN); PENG, Taiyan, Xuzhou, Jiangsu 221300 (CN); HU, Dongdong, Xuzhou, Jiangsu 221300 (CN); XU, Kaidong, Xuzhou, Jiangsu 221300 (CN)
(74) Representative: Eisenführ Speiser
(86) International application number: PCT/CN2021/134976
(87) International publication number: WO 2023/019804

(56) References cited:
- CN-A- 108 232 002
- CN-A- 108 242 504
- US-A1- 2015 255 507
- US-A1- 2017 263 861
- US-A1- 2018 033 957
- US-A1- 2020 136 026

## Description

This application claims priority to Chinese Patent Application No. 202110962630.7, titled "METHOD FOR REDUCING DAMAGE TO MAGNETIC TUNNEL JUNCTION OF MRAM", filed on August 20, 2021 with the China National Intellectual Property Administration.

### FIELD

The present disclosure relates to the technical field of semiconductor-chip manufacture, and in particular to a method for reducing damage to a magnetic tunnel junction of a MRAM.

### BACKGROUND

Continuous development of science and technology engenders wide application of various memories in people's lives and work, which brings great convenience.

Magnetic random access memories (MRAMs) are a new type of random access memories in the market. The MRAMs have higher reading/writing speed than that of conventional flash memories, and have radiation resistance and non-volatility which are lacked in traditional dynamic random-access memories (DRAMs) and static random-access memories (SRAMs). The MRAMs alone can achieve various storage functions which once can be implemented only by a combination of the three traditional types of memories.

When being manufactured through conventional processes, a crystal structure at a sidewall of a magnetic tunnel junction (MTJ) in the MRAM would be damaged during the processing and thereby results in a failure of MRAM devices. US 2017/263861 A1 discloses that some etched material would be redeposited on a side wall of the MTJ structure during anisotropy etching. US 2020/136026 A1 discloses magnetic electrodes may be fabricated through ion beam etching. US 2015/255507 A1 discloses that a spacer layer may be deposited on the MRAM bit to prevent byproducts formed in layer processing.

### SUMMARY

A method for reducing damage to a magnetic tunnel junction (MTJ) of a magnetic random access memory (MRAM) is provided according to embodiments of the present invention, which addresses the above issue. Technical solutions are as follows.

A method for reducing damage to MTJ of MRAM is provided according to an embodiment of the present invention and is defined in claim 1.

In one embodiment, performing the first etching comprises: performing the first etching on the surface of the upper electrode through ion beam etching, until the lower electrode is exposed, where in the ion beam etching, an incident angle of an ion beam ranges from 10° to 60°, energy of ions ranges from 50V to 600V, a bias voltage for accelerating the ions ranges from 50V to 1000V, a flow rate of a gas ranges from 10sccm to 500sccm, and the gas comprises one or more of: an inert gas, nitrogen, oxygen, a fluorine-based gas, an amine gas, carbon monoxide, carbon dioxide, and an alcohol gas.

In one embodiment, performing the first etching comprises: performing the first etching on the surface of the upper electrode through reactive ion etching, until the lower electrode is exposed, where in the reactive ion etching, power of a source electrode ranges from 500W to 2000W, power of a bias electrode ranges from 100W to 2000W, a pressure in an etching chamber ranges from 2mT to 20mT, a flow rate of a gas ranges from 10sccm to 500sccm, and the gas comprises one or more of: an inert gas, nitrogen, oxygen, a fluorine-based gas, an amine gas, carbon monoxide, carbon dioxide, and an alcohol gas.

In one embodiment, in the ion beam etching, an incident angle of an ion beam ranges from 30° to 60°, energy of ions ranges from 30V to 100V, a bias voltage for accelerating the ions ranges from 50V to 1000V, and a flow rate of a gas ranges from 10sccm to 500sccm.

In one embodiment, the gas comprises one or more of: nitrogen, oxygen, and hydrogen.

In one embodiment, duration of pre-processing the sidewall of the MTJ layer through the ion beam etching is less than or equal to 120 seconds.

In one embodiment, the preset thickness of the modified layer ranges from 1nm to 2nm.

In one embodiment, performing the second etching comprises: performing the second etching through ion beam etching, until the substrate is exposed, where in the ion beam etching, an incident angle of an ion beam ranges from 10° to 60°, energy of ions ranges from 50V to 600V, a bias voltage for accelerating the ions ranges from 50V to 1000V, a flow rate of a gas ranges from 10sccm to 500sccm, and the gas comprises one or more of: an inert gas, nitrogen, oxygen, a fluorine-based gas, an amine gas, carbon monoxide, carbon dioxide, and an alcohol gas.

In one embodiment, the second etching comprises: performing the second etching through reactive ion etching, until the substrate is exposed, where in the reactive ion etching, power of a source electrode ranges from 500W to 2000W, power of a bias electrode ranges from 100W to 2000W, a pressure in an etching chamber ranges from 2mT to 20mT, a flow rate of a gas ranges from 10sccm to 500sccm, and the gas comprises one or more of: an inert gas, nitrogen, oxygen, a fluorine-based gas, an amine gas, carbon monoxide, carbon dioxide, and an alcohol gas.

Embodiments of the present invention are advantageous over conventional technology in at least following aspects.

Herein the sidewall of the MTJ layer is pre-processed to trigger the reaction, so as to form the modified layer having the preset thickness. The modified layer is capable to scatter incident ions in subsequent etching processes, and hence minimizes the damage to the MTJ.

### BRIEF DESCRIPTION OF THE DRAWINGS

Hereinafter drawings to be applied in embodiments of the present invention or in conventional technology are briefly described, in order to clarify illustration of technical solutions according to embodiments of the present invention or in conventional technology. Apparently, the drawings in the following descriptions are only some embodiments of the present invention, and other drawings may be obtained by those skilled in the art based on the provided drawings without exerting creative efforts.
Figure 1 is a schematic structural diagram of a single bin of a magnetic random access memory (MRAM).
Figure 2 is a schematic diagram of an operation principle of a magnetic tunnel junction (MTJ).
Figure 3 is a schematic structural diagram of a single bin of another MRAM.
Figure 4 is a schematic diagram of a MRAM being damaged during processing, where the damage part is generally called MTJ damage.
Figure 5 is a schematic flowchart of a method for reducing damage to a MTJ of a MRAM according to an embodiment of the present invention.
Figures 6 to 9 are schematic diagrams of partial structures corresponding to a method as shown in Figure 5 according to an embodiment of the present invention.
Figure 10 is a schematic diagram of a comparative effect between MTJ layers with and without, respectively, pre-processing according to an embodiment of the present invention.

### DETAILED DESCRIPTION OF EMBODIMENTS

Hereinafter technical solutions in embodiments of the present invention are described clearly and completely in conjunction with the drawings in embodiments of the present invention. Apparently, the described embodiments are only some rather than all of the embodiments of the present invention. Any other embodiments obtained based on the embodiments of the present invention by those skilled in the art without any creative effort fall within the scope of protection of the present invention defined by the appended claims.

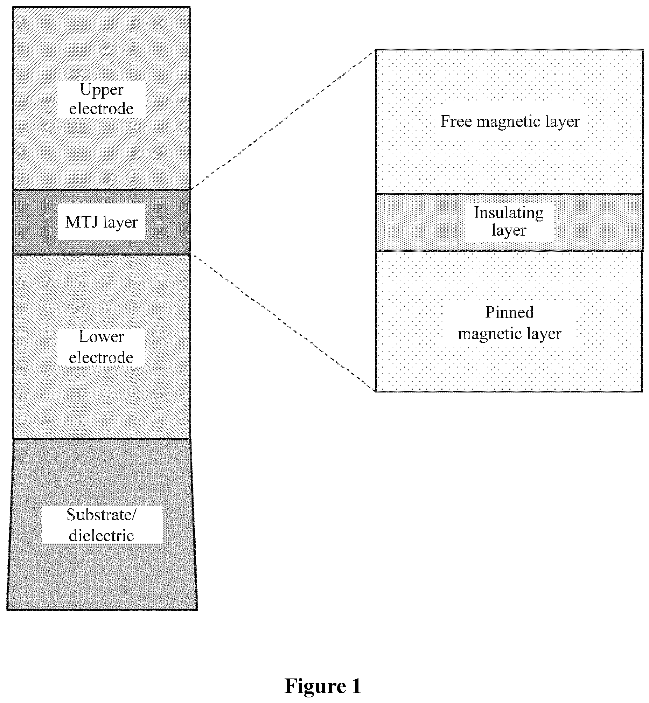

Reference is made to Figure 1 on a basis of content in the background. Figure 1 is a schematic structural diagram of a single bin of a magnetic random access memory (MRAM). As shown in Figure 1, an entire MRAM structure is disposed on a substrate, and there are a lower electrode, a magnetic tunnel junction (MTJ), and an upper electrode, which are arranged in the above-listed sequence along a certain direction. The MTJ is a key structure of a MRAM device. As shown in Figure 1, the MTJ comprises a pinned magnetic layer, an insulating layer, and a free magnetic layer, which are arranged along such direction.

The direction is perpendicular to the substrate, and points from the substrate toward the lower electrode.

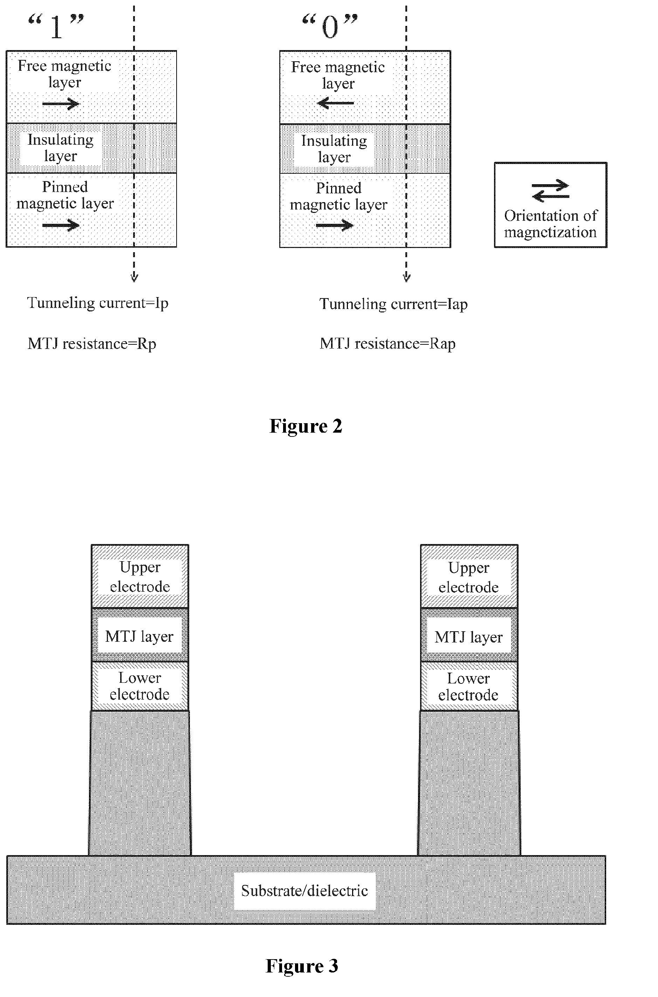

Reference is made to Figure 2 on a basis of the MRAM structure as shown in Figure 1. Figure 2 is a schematic diagram of an operation principle of an MTJ. As shown in Figure 2, when applying a voltage across the MTJ, a current is capable to pass through tunneling due to a quite small thickness (which is generally several nanometers) of the insulating layer. An orientation of magnetization in the pinned magnetic layer is fixed, and an orientation of magnetization in the free magnetic layer is switchable.

In a case that the orientation of magnetization of the pinned magnetic layer and that of the free magnetic layer are parallel, the resistance Rp of the MTJ is small, and a tunneling current Ip is large. In such case, the entire structure may be regarded as being in an on-state, which represents a bin of "1".

In a case that the orientation of magnetization of the pinned magnetic layer and that of the free magnetic layer are anti-parallel, the resistance Rap of the MTJ is large, and the tunneling current Iap is small. In such case, the entire structure may be regarded as being in an off-state, which represents a bin of "0".

A performance of the MTJ is calibrated by tunneling magnetoresistance (TMR), of which an equation is as follows: $TMR = \left(\frac{R ap - R p}{R p}\right)$

The larger the TMR is, the better the performance of the MRAM is.

It is discovered that the greater a difference between the on-state resistance (Rp) and the off-state resistance (Rap) is, the better the device performance is.

The operation principle of MTJ reveals that a key factor in operation of the MTJ is ensuring good insulation of the insulating layer, which limits that electrons have the tunneling as their only passing means and cannot travel between the pinned magnetic layer and the free magnetic layer directly via the insulating layer (which causes a leak).

A performance of the insulating layer is generally calibrated by RA. In one embodiment, RA is a product of resistance (R) and an area (A) of the insulating layer. The larger the RA is, the better the device performance is.

Reference is made to Figure 3, which is a schematic structural diagram of a single bin of another MRAM. Multiple single-bin structures, as shown in Figure 1, of the MRAM are arranged into an array and are interconnected via wiring, such that a simple MRAM storage structure as shown in Figure 3 is formed.

As shown in Figure 3, a trench is formed between different single-bin structures of MRAM. The trench may be regards as a part of an MTJ structure in the MRAM.

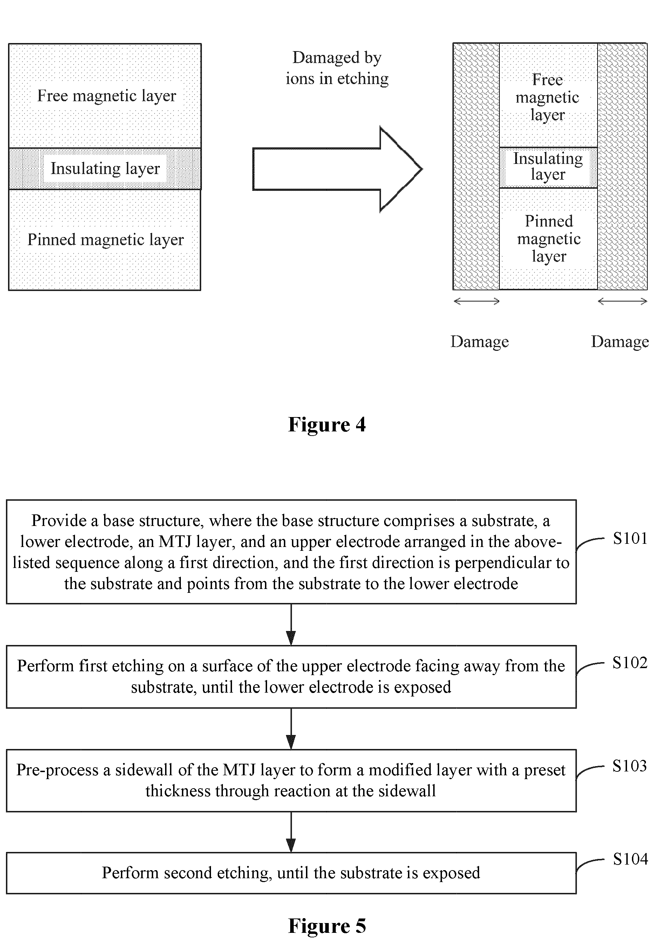

Generally, ion beam etching is performed during manufacture of the MRAM. During the ion beam etching, ions with certain energy would destroy a crystal structure at a sidewall of the MTJ layer. Reference is made to Figure 4, which is a schematic diagram of damage induced during manufacturing an MRAM. The damaged part of the structure is usually called MTJ damage.

The MTJ damage would reduce the area (A) of the insulating layer, thereby reduces RA, which deteriorates the device performance.

In view of the above, a conventional solution is reducing energy of ions as much as possible during the etching, in order to reduce the damage. Such solution is subject to a main problem that the reduced energy of ions results in a reduced etching rate and thereby a reduced yield.

Another conventional solution is removing the MTJ damage through a chemical means. Such solution is somehow makeshift since they merely remove the already formed damage rather than reducing the damage, and the insulation layer still shrinks in such solution.

A method for reducing damage MTJ of MRAM is provided according to embodiments of the present invention. The MTJ damage can be greatly reduced, thereby improving the performance of MRAM device.

Hereinafter the present invention is further illustrated in detail in conjunction with the drawings and specific embodiments, so as clarify and elucidate the above objectives, features, and advantages of the present invention.

Reference is made to Figure 5, which is a schematic flowchart of a method for reducing damage to a MTJ of a MRAM according to an embodiment of the present invention.

The method comprises following steps S101 to S104.

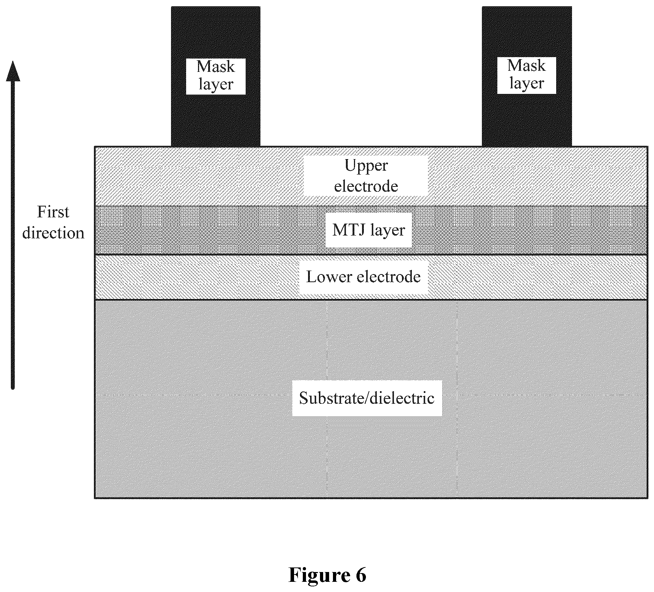

In step S101, a base structure is provided, as shown in Figure 6. The base structure comprises a substrate, a lower electrode, an MTJ layer, and an upper electrode, which are arranged in the above-listed sequence along a first direction. The first direction is perpendicular to the substrate, and points from the substrate to the lower electrode.

In this step, a mask layer may be formed on a surface of the upper electrode facing away from the substrate, before performing subsequent first etching. The mask layer comprises multiple mask units.

That is, the mask layer is formed on the base structure, that is, on the surface of the upper electrode facing away from the MTJ layer. A material of the mask layer may be TiN, Ta, C, Si, SiO, SiN, or a combination of the above, which is not limited herein and may depend on an actual situation.

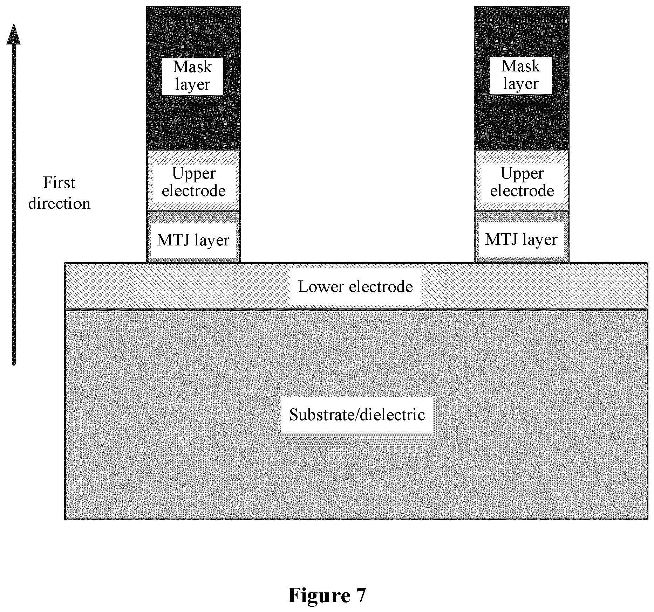

In step S102, a first etching is performed on the surface of the upper electrode facing away from the substrate until the lower electrode is exposed, as shown in Figure 7.

In this step, a degree of the first etching needs to be determined according to an actual situation. It is ensured that the first etching stops at an interface between the MTJ layer and the lower electrode.

In one embodiment, the first etching comprises a following step. The first etching is performed on the surface of the upper electrode facing away from the substrate through ion beam etching, until the lower electrode is exposed.

That is, a means of the first etching is ion beam etching (IBE). In one embodiment, the ion beam etching is configured as follows. An incident angle of an ion beam ranges from 10° to 60°, energy of ions ranges from 50V to 600V, a bias voltage for accelerating the ions ranges from 50V to 1000V, and a flow rate of a gas ranges from 10sccm to 500sccm. The gas is an inert gas, nitrogen, oxygen, a fluorine-based gas, an amine gas, carbon monoxide, carbon dioxide, an alcohol gas, or a combination of the above.

In an alternative embodiment, the first etching comprises a following step. The first etching is performed on the surface of the upper electrode facing away from the substrate through reactive ion etching, until the lower electrode is exposed.

That is, a means of the first etching is reactive ion etching (RIE). In one embodiment, the reactive ion etching is configured as follows. Power of a source electrode ranges from 500W to 2000W, power of a bias electrode ranges from 100W to 2000W, a pressure in an etching chamber ranges from 2mT to 20mT, and a flow rate of a gas ranges from 10sccm to 500sccm. The gas is an inert gas, nitrogen, oxygen, a fluorine-based gas, an amine gas, carbon monoxide, carbon dioxide, an alcohol gas, or a combination of the above.

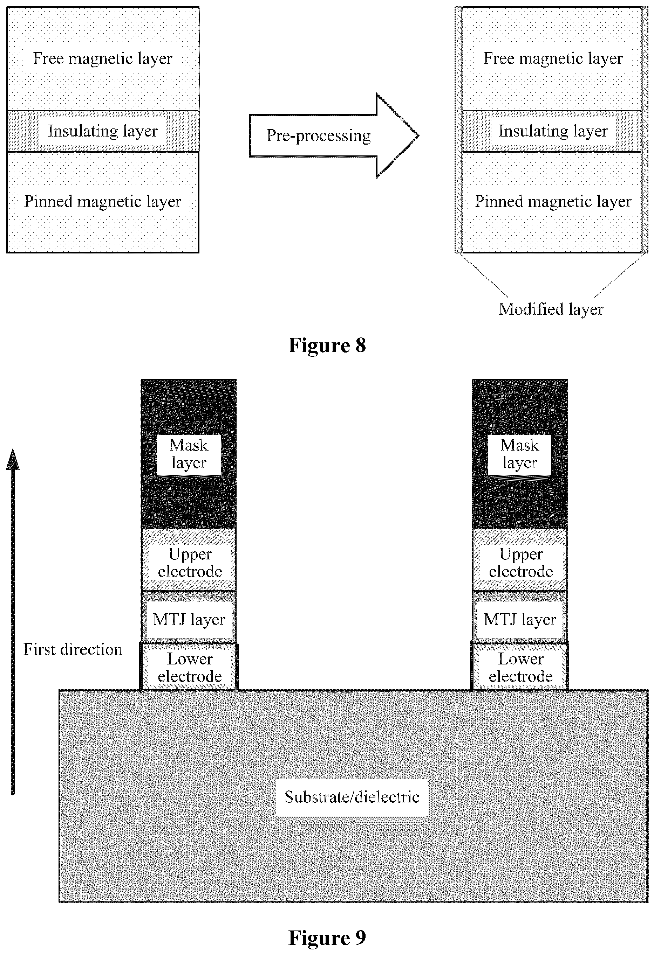

In step S103, the sidewall of the MTJ layer is pre-processed, so as to form a modified layer with a preset thickness through reaction at the sidewall, as shown in Figure 8.

In step S104, second etching is performed until the substrate is exposed, as shown in Figure 9.

In this step, a degree of the second etching needs to be determined according to an actual situation. It is ensured that the second etching stops at an interface between the lower electrode and the substrate.

In one embodiment, the second etching comprises a following step. The second etching is performed through ion beam etching, until the substrate is exposed.

That is, a means of the second etching is ion beam etching (IBE). In one embodiment, the ion beam etching is configured as follows. An incident angle of an ion beam ranges from 10° to 60°, energy of ions ranges from 50V to 600V, a bias voltage for accelerating the ions ranges from 50V to 1000V, and a flow rate of a gas ranges from 10sccm to 500sccm. The gas is an inert gas, nitrogen, oxygen, a fluorine-based gas, an amine gas, carbon monoxide, carbon dioxide, an alcohol gas, or a combination of the above.

In an alternative embodiment, the second etching comprises a following step. The second etching is performed through reactive ion etching, until the substrate is exposed.

That is, a means of the second etching is reactive ion etching (RIE). In one embodiment, the reactive ion etching is configured as follows. Power of a source electrode ranges from 500W to 2000W, power of a bias electrode ranges from 100W to 2000W, a pressure in an etching chamber ranges from 2mT to 20mT, and a flow rate of a gas ranges from 10sccm to 500sccm. The gas is an inert gas, nitrogen, oxygen, a fluorine-based gas, an amine gas, carbon monoxide, carbon dioxide, an alcohol gas, or a combination of the above.

Herein the sidewall of the MTJ layer is pre-processed, such that reaction at the sidewall of the MTJ layer forms the modified layer with the preset thickness. The modified layer is capable scatter incident ions in subsequent etching, so as to minimize the MTJ damage.

According to the present invention, preprocessing the sidewall of the MTJ layer to form the modified layer through the reaction at the sidewall comprises a following step. The sidewall of the MTJ layer is processed through ion beam etching to form the modified layer through the reaction at the sidewall, after the whole sidewall is exposed.

In one embodiment, the ion beam etching is configured as follows. An incident angle of an ion beam ranges from 30° to 60°, energy of ions ranges from 30V to 100V, a bias voltage for accelerating the ions ranges from 50V to 1000V, and a flow rate of a gas ranges from 10sccm to 500sccm.

In one embodiment, the gas for the ion beam etching is nitrogen, oxygen, hydrogen, or a combination of the above.

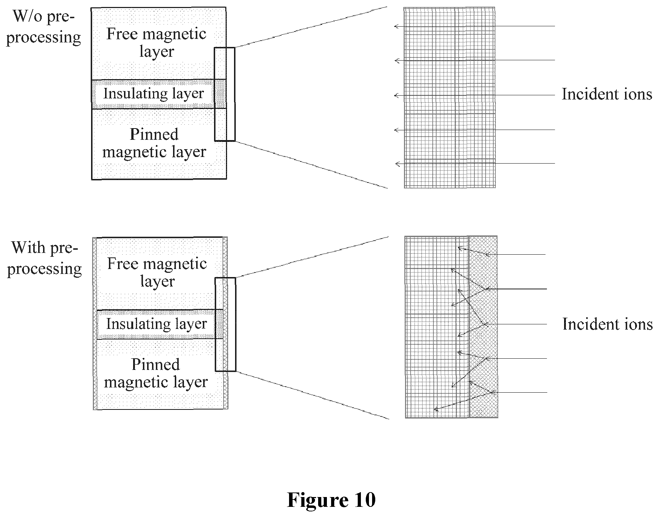

Reference is made to Figure 10, which is a schematic diagram of a comparative effect between MTJ layers with or without, respectively, pre-processing according to an embodiment of the present invention. As shown in Figure 10, a lattice structure of the sidewall of the MTJ layer without the pre-processing is regular in arrangement, and the incident ions in subsequent etching is highly like to travel deep via the lattice. Such phenomenon is called the passage effect. In such case, the incident ions in subsequent etching would induce deep MTJ damage into the MTJ layer.

In comparison, the lattice structure of the sidewall of the MTJ layer subject to pre-processing has been altered under nitrogen, oxygen, hydrogen, or a combination of the above, and thus the modified layer with the preset thickness has been formed. The incident ions in subsequent etching can be scattered in the modified layer, which weakens the passage effect. Thereby, the MTJ damage is reduced, and the device performance is improved.

In one embodiment, duration of pre-processing the sidewall through the ion beam etching is less than or equal to 120 seconds.

In this embodiment, the duration of pre-processing the sidewall through the ion beam etching is controlled, so as to control the thickness of the modified layer. Thereby, an optimal thickness can be achieved.

In a case that the etching duration is greater than 120 seconds, the thickness of the modified layer is too large and introduces the actual MTJ damage. Hence, the etching duration is controlled to be appropriate, such that the final thickness of the modified layer can prevent expansion of the MTJ damage in subsequent processing to the greatest extent.

In one embodiment, the thickness of the modified layer ranges from 1 nm to 2 nm.

Herein the substrate may be a dielectric layer made of multiple materials, and hence it is denoted as "substrate/dielectric" in the drawings. A specific material of the substrate is not limited herein.

Hereinabove the method for reducing the damage to the MTJ of the MRAM according embodiments of the present invention is illustrated in detail. Specific embodiments are utilized herein to illustrate principles and implementations of the present invention. The description of the above embodiments is only intended for helping understand the method and core concepts of the present invention. Those skilled in the art may make modifications on specific implementations and application scenarios based on the concepts of the present disclosure. In summary, content of the present disclosure should not be construed as limitations of the present invention. The present invention is solely defined by the appended claims.

The embodiments of the present invention are described in a progressive manner, and each embodiment places emphasis on the difference from other embodiments. Therefore, one embodiment can refer to other embodiments for the same or similar parts. Since apparatuses disclosed in the embodiments correspond to methods disclosed in the embodiments, the description of the apparatuses is simple, and reference may be made to the relevant part of the methods.

The relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article or a device including a series of elements include not only the disclosed elements but also other elements that are not clearly enumerated, or further include inherent elements of the process, the method, the article or the device. Unless expressively limited, the statement "including a..." does not exclude the case that other similar elements may exist in the process, the method, the article or the device other than enumerated elements.

According to the description of the disclosed embodiments, those skilled in the art can implement or use the present invention. Various modifications made to these embodiments may be obvious to those skilled in the art, and the general principle defined herein may be implemented in other embodiments.

## Claims

1. A method for reducing damage to a magnetic tunnel junction, MTJ, of a magnetic random access memory, MRAM, comprising:
providing (S101) a base structure, wherein the base structure comprises a substrate, a lower electrode, an MTJ layer, and an upper electrode, which are arranged in the above-listed sequence along a first direction, and the first direction is perpendicular to the substrate and points from the substrate to the lower electrode;
performing (S102) first etching on a surface of the upper electrode facing away from the substrate until the lower electrode is exposed;
pre-processing (S103) a sidewall of the MTJ layer to form a modified layer with a preset thickness through reaction at the sidewall of the MTJ layer; and
performing (S104) second etching until the substrate is exposed;
**characterized in that**:
pre-processing (S103) the sidewall of the MTJ layer to form the modified layer with the preset thickness through the reaction at the sidewall of the MTJ layer comprises:
processing, when all the sidewall is exposed, the sidewall of the MTJ layer through ion beam etching to form the modified layer with the preset thickness through the reaction at the sidewall of the MTJ layer;
wherein the preset thickness is selected such that the modified layer scatters incident ions during the second etching.

2. The method according to claim 1, wherein performing (S102) the first etching comprises:
performing the first etching on the surface of the upper electrode through ion beam etching, until the lower electrode is exposed, wherein in the first etching through ion beam etching:
an incident angle of an ion beam ranges from 10° to 60°,
energy of ions ranges from 50V to 600V,
a bias voltage for accelerating the ions ranges from 50V to 1000V,
a flow rate of a gas ranges from 10sccm to 500sccm, and
the gas comprises one or more of: an inert gas, nitrogen, oxygen, a fluorine-based gas, an amine gas, carbon monoxide, carbon dioxide, and an alcohol gas.

3. The method according to claim 1, wherein performing (S102) the first etching comprises:
performing the first etching on the surface of the upper electrode through reactive ion etching, until the lower electrode is exposed, wherein in the reactive ion etching:
power of a source electrode ranges from 500W to 2000W,
power of a bias electrode ranges from 100W to 2000W,
a pressure in an etching chamber ranges from 2mT to 20mT,
a flow rate of a gas ranges from 10sccm to 500sccm, and
the gas comprises one or more of: an inert gas, nitrogen, oxygen, a fluorine-based gas, an amine gas, carbon monoxide, carbon dioxide, and an alcohol gas.

4. The method according to claim 1, wherein in the ion beam etching:
an incident angle of an ion beam ranges from 30° to 60°,
energy of ions ranges from 30V to 100V,
a bias voltage for accelerating the ions ranges from 50V to 1000V, and
a flow rate of a gas ranges from 10sccm to 500sccm.

5. The method according to claim 4, wherein the gas comprises one or more of: nitrogen, oxygen, and hydrogen.

6. The method according to claim 1, wherein duration of processing the sidewall of the MTJ layer through the ion beam etching is less than or equal to 120 seconds.

7. The method according to claim 1, wherein the preset thickness of the modified layer ranges from 1nm to 2nm.

8. The method according to claim 1, wherein performing (S104) the second etching comprises:
performing the second etching through ion beam etching, until the substrate is exposed, wherein in the second etching through ion beam etching:
an incident angle of an ion beam ranges from 10° to 60°,
energy of ions ranges from 50V to 600V,
a bias voltage for accelerating the ions ranges from 50V to 1000V,
a flow rate of a gas ranges from 10sccm to 500sccm, and
the gas comprises one or more of: an inert gas, nitrogen, oxygen, a fluorine-based gas, an amine gas, carbon monoxide, carbon dioxide, and an alcohol gas.

9. The method according to claim 1, wherein the second etching comprises:
performing the second etching through reactive ion etching, until the substrate is exposed, wherein in the reactive ion etching:
power of a source electrode ranges from 500W to 2000W,
power of a bias electrode ranges from 100W to 2000W,
a pressure in an etching chamber ranges from 2mT to 20mT,
a flow rate of a gas ranges from 10sccm to 500sccm, and
the gas comprises one or more of: an inert gas, nitrogen, oxygen, a fluorine-based gas, an amine gas, carbon monoxide, carbon dioxide, and an alcohol gas.

## Patentansprüche

1. Verfahren zur Schadensverringerung eines magnetischen Tunnelkontakts, MTJ, eines magnetischen Direktzugriffsspeichers, MRAM, umfassend:
Bereitstellen (S101) einer Grundstruktur, wobei die Grundstruktur ein Substrat, eine untere Elektrode, eine MTJ-Schicht und eine obere Elektrode umfasst, die in der oben aufgeführten Reihenfolge entlang einer ersten Richtung angeordnet sind, und die erste Richtung senkrecht zum Substrat verläuft und vom Substrat zur unteren Elektrode zeigt;
Durchführen (S102) eines ersten Ätzens auf einer dem Substrat abgewandten Oberfläche der oberen Elektrode, bis die untere Elektrode freigelegt ist;
Vorbehandeln (S103) einer Seitenwand der MTJ-Schicht, um durch Reaktion an der Seitenwand der MTJ-Schicht eine modifizierte Schicht mit einer vorbestimmten Dicke zu bilden; und
Durchführen (S104) eines zweiten Ätzens, bis das Substrat freigelegt ist;
**dadurch gekennzeichnet, dass**:
das Vorbehandeln (S103) der Seitenwand der MTJ-Schicht, um durch die Reaktion an der Seitenwand der MTJ-Schicht die modifizierte Schicht mit der vorbestimmten Dicke zu bilden, umfasst:
Behandeln der Seitenwand der MTJ-Schicht durch Ionenstrahlätzen, wenn die gesamte Seitenwand freigelegt ist, um durch die Reaktion an der Seitenwand der MTJ-Schicht die modifizierte Schicht mit der vorbestimmten Dicke zu bilden;
wobei die vorbestimmte Dicke derart gewählt ist, dass die modifizierte Schicht einfallende Ionen während des zweiten Ätzens streut.

2. Verfahren nach Anspruch 1, wobei das Durchführen (S102) des ersten Ätzens umfasst:
Durchführen des ersten Ätzens an der Oberfläche der oberen Elektrode durch Ionenstrahlätzen, bis die untere Elektrode freigelegt ist, wobei bei dem ersten Ätzen durch das Ionenstrahlätzen:
ein Einfallswinkel eines Ionenstrahls im Bereich von 10° bis 60° liegt,
eine Energie der Ionen im Bereich von 50 V bis 600 V liegt,
eine Vorspannung zum Beschleunigen der Ionen im Bereich von 50 V bis 1000 V liegt,
ein Durchfluss eines Gases im Bereich von 10 sccm bis 500 sccm liegt und
das Gas eines oder mehrere von Folgendem umfasst: ein Inertgas, Stickstoff, Sauerstoff, ein fluorbasiertes Gas, ein Amin-Gas, Kohlenmonoxid, Kohlendioxid und ein Alkoholgas.

3. Verfahren nach Anspruch 1, wobei das Durchführen (S102) des ersten Ätzens umfasst:
Durchführen des ersten Ätzens an der Oberfläche der oberen Elektrode durch reaktives Ionenätzen, bis die untere Elektrode freigelegt ist, wobei bei dem reaktiven Ionenätzen:
eine Leistung einer Quellenelektrode im Bereich von 500 W bis 2000 W liegt,
eine Leistung einer Vorspannungselektrode im Bereich von 100 W bis 2000 W liegt,
ein Druck in einer Ätzkammer im Bereich von 2 mT bis 20 mT liegt,
ein Durchfluss eines Gases im Bereich von 10 sccm bis 500 sccm liegt, und
das Gas eines oder mehrere von Folgendem umfasst: ein Inertgas, Stickstoff, Sauerstoff, ein fluorbasiertes Gas, ein Amin-Gas, Kohlenmonoxid, Kohlendioxid und ein Alkoholgas.

4. Verfahren nach Anspruch 1, wobei bei dem Ionenstrahlätzen:
ein Einfallswinkel eines Ionenstrahls im Bereich von 30° bis 60° liegt,
eine Energie der Ionen im Bereich von 30 V bis 100 V liegt,
eine Vorspannung zum Beschleunigen der Ionen im Bereich von 50 V bis 1000 V liegt, und
ein Durchfluss eines Gases im Bereich von 10 sccm bis 500 sccm liegt.

5. Verfahren nach Anspruch 4, wobei das Gas eines oder mehrere von Folgendem umfasst: Stickstoff, Sauerstoff und Wasserstoff.

6. Verfahren nach Anspruch 1, wobei eine Dauer des Behandelns der Seitenwand der MTJ-Schicht durch das Ionenstrahlätzen kleiner oder gleich 120 Sekunden ist.

7. Verfahren nach Anspruch 1, wobei die vorbestimmte Dicke der modifizierten Schicht im Bereich von 1 nm bis 2 nm liegt.

8. Verfahren nach Anspruch 1, wobei das Durchführen (S104) des zweiten Ätzens umfasst:
Durchführen des zweiten Ätzens durch Ionenstrahlätzen, bis das Substrat freigelegt ist, wobei bei dem zweiten Ätzen durch das Ionenstrahlätzen:
ein Einfallswinkel eines Ionenstrahls im Bereich von 10° bis 60° liegt,
eine Energie der Ionen im Bereich von 50 V bis 600 V liegt,
eine Vorspannung zum Beschleunigen der Ionen im Bereich von 50 V bis 1000 V liegt,
ein Durchfluss eines Gases im Bereich von 10 sccm bis 500 sccm liegt, und
das Gas eines oder mehrere von Folgendem umfasst: ein Inertgas, Stickstoff, Sauerstoff, ein fluorbasiertes Gas, ein Amin-Gas, Kohlenmonoxid, Kohlendioxid und ein Alkoholgas.

9. Verfahren nach Anspruch 1, wobei das zweite Ätzen umfasst:
Durchführen des zweiten Ätzens durch reaktives Ionenätzen, bis das Substrat freigelegt ist, wobei bei dem reaktiven Ionenätzen:
eine Leistung einer Quellenelektrode im Bereich von 500 W bis 2000 W liegt,
eine Leistung einer Vorspannungselektrode im Bereich von 100 W bis 2000 W liegt,
ein Druck in einer Ätzkammer im Bereich von 2 mT bis 20 mT liegt,
ein Durchfluss eines Gases im Bereich von 10 sccm bis 500 sccm liegt, und
das Gas eines oder mehrere von Folgendem umfasst: ein Inertgas, Stickstoff, Sauerstoff, ein fluorbasiertes Gas, ein Amin-Gas, Kohlenmonoxid, Kohlendioxid und ein Alkoholgas.

## Revendications

1. Procédé de réduction des dommages à une jonction de tunnel magnétique, MTJ, d'une mémoire vive magnétique, MRAM, comprenant :
la fourniture (S101) d'une structure de base, dans lequel la structure de base comprend un substrat, une électrode inférieure, une couche MTJ et une électrode supérieure, qui sont agencées dans la séquence énumérée ci-dessus le long d'une première direction, et la première direction est perpendiculaire au substrat et pointe du substrat vers l'électrode inférieure ;
la réalisation (S102) d'une première gravure sur une surface de l'électrode supérieure faisant face à l'opposé du substrat jusqu'à ce que l'électrode inférieure soit exposée ;
le prétraitement (S103) d'une paroi latérale de la couche MTJ pour former une couche modifiée avec une épaisseur prédéfinie par réaction au niveau de la paroi latérale de la couche MTJ, et
la réalisation (S104) d'une deuxième gravure jusqu'à ce que le substrat soit exposé ;
**caractérisé en ce que** :
le prétraitement (S103) de la paroi latérale de la couche MTJ pour former la couche modifiée avec l'épaisseur prédéfinie par réaction au niveau de la paroi latérale de la couche MTJ comprend :
le traitement, lorsque toute la paroi latérale est exposée, de la paroi latérale de la couche MTJ par gravure par faisceau d'ions pour former la couche modifiée avec l'épaisseur prédéfinie par réaction au niveau de la paroi latérale de la couche MTJ ;
dans lequel l'épaisseur prédéfinie est choisie de telle sorte que la couche modifiée diffuse des ions incidents pendant la deuxième gravure.

2. Procédé selon la revendication 1, dans lequel la réalisation (S102) de la première gravure comprend :
la réalisation de la première gravure sur la surface de l'électrode supérieure par gravure par faisceau d'ions, jusqu'à ce que l'électrode inférieure soit exposée, dans lequel dans la première gravure par gravure par faisceau d'ions :
un angle d'incidence d'un faisceau d'ions est compris entre 10° et 60°,
l'énergie des ions est comprise entre 50 V et 600 V,
une tension de polarisation pour accélérer les ions est comprise entre 50 V et 1 000 V,
un débit d'un gaz est compris entre 10 cm³/min et 500 cm³/min, et
le gaz comprend un ou plusieurs parmi : un gaz inerte, de l'azote, de l'oxygène, un gaz à base de fluor, un gaz à base d'amine, du monoxyde de carbone, du dioxyde de carbone et un gaz à base d'alcool.

3. Procédé selon la revendication 1, dans lequel la réalisation (S102) de la première gravure comprend :
la réalisation de la première gravure sur la surface de l'électrode supérieure par gravure d'ions réactifs, jusqu'à ce que l'électrode inférieure soit exposée, dans lequel dans la gravure d'ions réactifs :
la puissance d'une électrode source est comprise entre 500 W et 2 000 W,
la puissance d'une électrode de polarisation est comprise entre 100 W et 2 000 W,
une pression dans une chambre de gravure est comprise entre 2 mT et 20 mT,
un débit d'un gaz est compris entre 10 cm³/min et 500 cm³/min, et
le gaz comprend un ou plusieurs parmi : un gaz inerte, de l'azote, de l'oxygène, un gaz à base de fluor, un gaz à base d'amine, du monoxyde de carbone, du dioxyde de carbone et un gaz à base d'alcool.

4. Procédé selon la revendication 1, dans lequel dans la gravure par faisceau d'ions :
un angle d'incidence d'un faisceau d'ions est compris entre 30° et 60°,
l'énergie des ions est comprise entre 30 V et 100 V,
une tension de polarisation pour accélérer les ions est comprise entre 50 V et 1 000 V, et
un débit d'un gaz est compris entre 10 cm³/min et 500 cm³/min.

5. Procédé selon la revendication 4,
dans lequel le gaz comprend un ou plusieurs parmi : de l'azote, de l'oxygène et de l'hydrogène.

6. Procédé selon la revendication 1, dans lequel la durée de traitement de la paroi latérale de la couche MTJ par gravure par faisceau d'ions est inférieure ou égale à 120 secondes.

7. Procédé selon la revendication 1, dans lequel l'épaisseur prédéfinie de la couche modifiée est comprise entre 1 nm et 2 nm.

8. Procédé selon la revendication 1, dans lequel la réalisation (S104) de la deuxième gravure comprend :
la réalisation de la deuxième gravure par gravure par faisceau d'ions, jusqu'à ce que le substrat soit exposé, dans lequel dans la deuxième gravure par gravure par faisceau d'ions :
un angle d'incidence d'un faisceau d'ions est compris entre 10° et 60°,
l'énergie des ions est comprise entre 50 V et 600 V,
une tension de polarisation pour accélérer les ions est comprise entre 50 V et 1 000 V,
un débit d'un gaz est compris entre 10 cm³/min et 500 cm³/min, et
le gaz comprend un ou plusieurs parmi : un gaz inerte, de l'azote, de l'oxygène, un gaz à base de fluor, un gaz à base d'amine, du monoxyde de carbone, du dioxyde de carbone et un gaz à base d'alcool.

9. Procédé selon la revendication 1, dans lequel la deuxième gravure comprend :
la réalisation de la deuxième gravure par gravure d'ions réactifs, jusqu'à ce que le substrat soit exposé, dans lequel dans la gravure d'ions réactifs :
la puissance d'une électrode source est comprise entre 500 W et 2 000 W,
la puissance d'une électrode de polarisation est comprise entre 100 W et 2 000 W,
une pression dans une chambre de gravure est comprise entre 2 mT et 20 mT,
un débit d'un gaz est compris entre 10 cm³/min et 500 cm³/min, et
le gaz comprend un ou plusieurs parmi : un gaz inerte, de l'azote, de l'oxygène, un gaz à base de fluor, un gaz à base d'amine, du monoxyde de carbone, du dioxyde de carbone et un gaz à base d'alcool.
